# EUROPEAN PATENT APPLICATION

(11) **EP 3 029 175 A1**
(43) Date of publication of application: **08.06.2016**
(21) Application number: 14196567.3
(22) Date of filing: 05.12.2014
(51) Int. Cl.: C23C 16/455, H01L 21/02, C23C 16/30, C23C 16/56, H01L 21/768

(54) **Process for the production of porous thin films**

(71) Applicant: BASF SE, 67056 Ludwigshafen am Rhein (DE)
(72) Inventor: Ruettinger, Wolfgang, East Windsor, NJ 08520 (US); Wagloehner, Steffen, 76669 Bad Schoenborn (DE); Loeffler, Daniel, 67134 Birkenheide (DE); Ahlf, Maraike, 69198 Schriesheim (DE)
(74) Representative: BASF IP Association

(57) **Abstract**

The present invention relates to the production of porous thin films, in particular by atomic layer deposition. The present invention relates to a process for producing porous films comprising the steps
(a) exposing a solid substrate to a vapor containing an organic compound (A), whereby a submonolayer of the organic compound (A) covalently bound to the surface of the solid substrate is formed,
(b) exposing the solid substrate to a vapor containing a compound of general formula (I) SiX₄ (I),
wherein X is hydrogen, a halogen, an alkoxy, an aryloxy, or an amine group,
(c) exposing the solid substrate to a vapor containing an organic compound (B) which has at least two functional groups out of which at least one can form a covalent bond with the surface-bound organic compound (A),
(d) performing the steps
(d1) exposing the solid substrate to a vapor containing water, and
(d2) exposing the solid substrate to a vapor containing a compound of general formula (I), (e) exposing the solid substrate to a vapor containing an organic compound (C) which has at least two functional groups out of which at least one can form a covalent bond to the surface-bound organic compound (B),

(f) removing organic parts from the film formed on the surface of the solid substrate.

## Description

The present invention is in the field of production of porous thin films, in particular by atomic layer deposition. The present invention further relates to these porous thin films.

Materials with low dielectric constant are crucial for the advancement of microchips and are used in the so-called front-end-of-line (FEOL) as well as in the back-end-of-line (BEOL) of interconnects (IC). Since the node of the IC is steadily decreasing, RC delay, cross talking and parasitic power losses of ICs are becoming a serious problem. Amorphous silica is often used as material with low dielectric constant due to its high thermal stability. The dielectric constant of silica can be decreased by introducing pores into silica films. Processes to produce such films are known from prior art.

US 2012 / 074 535 discloses a process for producing a dielectric material by depositing alkyldisilanes by chemical vapor despoition (CVD) or by sol-gel and subsequently removing the alkyl groups.

US 2011 / 006 406 discloses a process for producing low-k films by codeposition of silica and an organic porogen by CVD or spin-on deposition and subsequent removal of the organic porogen.

The prior art processes have the disadvantage that they do not allow a good control over the film thickness, in particular on complex-shaped substrates, and over the pore size and its distribution. The mechanical strength of films with high porosity is thus not sufficient for a variety of applications.

It was an object of the present invention to provide a process with which films of a low dielectric constant are available. It was further aimed at a process which allows a good control over the film properties, in particular the pore size and distribution. Another object was to provide a process for the production of homogeneous films on complex-shaped substrates.

These objects were achieved by a process for producing porous films comprising the steps
(a) exposing a solid substrate to a vapor containing an organic compound (A), whereby a submonolayer of the organic compound (A) covalently bound to the surface of the solid substrate is formed,
(b) exposing the solid substrate to a vapor containing a compound of general formula (I) SiX₄ (I),
   wherein X is hydrogen, a halogen, an alkoxy, an aryloxy, or an amine group,
(c) exposing the solid substrate to a vapor containing an organic compound (B) which has at least two functional groups out of which at least one can form a covalent bond with the surface-bound organic compound (A),
(d) performing the steps
   (d1) exposing the solid substrate to a vapor containing water, and
   (d2) exposing the solid substrate to a vapor containing a compound of general formula (I),
(e) exposing the solid substrate to a vapor containing an organic compound (C) which has at least two functional groups out of which at least one can form a covalent bond to the surface-bound organic compound (B),
(f) removing organic parts from the film formed on the surface of the solid substrate.

The present invention further relates to an amorphous film on a solid substrate comprising silica having a thickness of up to 300 nm and pores with a volume average diameter of 0.1 to 4 nm wherein the standard deviation of the pore diameter is not more than 20 % of the volume average diameter.

The present invention further relates to the use of the film according to the present invention as insulator.

The present invention further relates to an electronic element comprising the film according to the present invention.

Preferred embodiments of the present invention can be found in the description and the claims. Combinations of different embodiments fall within the scope of the current invention.

### Step (a)

In the process according to the present invention a solid substrate is exposed to a vapor containing an organic compound (A). The solid substrate can be any solid material. These include for example metals, semimetals, oxides, nitrides, and polymers. It is also possible that the substrate is a mixture of different materials. Examples for metals are aluminum, steel, zinc, and copper. Examples for semimetals are silicon, germanium, and gallium arsenide. Examples for oxides are silicon dioxide, titanium dioxide, and zinc oxide. Examples for nitrides are silicon nitride, aluminum nitride, titanium nitride, and gallium nitride. Examples for polymers are polyethylene terephthalate (PET), polyethylene naphthalene-dicarboxylic acid (PEN), and polyamides.

The solid substrate can have any shape. These include sheet plates, films, fibers, particles of various sizes, and substrates with trenches, mesopores, macropores or other indentations. The solid substrate can be of any size. If the solid substrate has a particle shape, the size of particles can range from below 100 nm to several centimeters, preferably from 1 µm to 1 mm. In order to avoid particles or fibers to stick to each other during the process according to the present invention, it is preferably to keep them in motion. This can, for example, be achieved by stirring, by rotating drums, or by fluidized bed techniques.

The organic compound (A) preferably has at least two functional groups, one of which can form a covalent bond with the surface of the substrate and at least one other can form a covalent bond with the organic compound (B). The at least two function groups can be the same or different to each other. Examples for functional groups are silicon-containing groups including trihalogenosilyl groups such as trichlorosilyl, azasilyl groups such as tris(dimethylamino)silyl; oxosilyl groups such as trimethoxysilyl; reactive carbonyl groups such as aldehydes, acid chlorides, acid anhydrides or isocyanates; strained rings such as ethylene oxide; or functional groups capable of participating in an electrocyclic addition reaction such as dienes, azides, ethynes, or nitriles. More preferably, the organic compound (A) contains a silicon-containing group and an amine group, for example N-methyl-aza-2,2,4-trimethylsilacyclopentane, or 3-aminopropyle-tris(dimethylamino)silane.

By exposing the solid substrate to a vapor containing the organic compound (A) a submonolayer of the organic compound (A) covalently bound to the surface of the solid substrate is formed. This can be achieved for example by exposing the solid substrate to a vapor containing the organic compound (A) at a low partial pressure, such as 0.01 to 10 mbar, preferably 0.1 to 1 mbar. Preferably, the solid substrate is exposed to a vapor containing the organic compound (A) for a short time, for example 0.01 to 10 s, in particular 0.1 to 1 s.

### Step (b)

According to the present invention the solid substrate is exposed to a vapor containing a compound of general formula (I). General formula (I) is SiX₄, wherein X is hydrogen, a halogen, an alkoxy, an aryloxy, an amine group. All X in the compound of general formula (I) can be the same or different to each other. If X are different to each other, it is possible that all X are different to each other or that two or three X are the same and the remaining X are different.

Halogens are preferably chloride, bromide or iodide, in particular chloride. Preferred examples for a compound of general formula (I) in which X is a halogen include tetrachlorosilane or tetrabromosilane. An alkoxy group can be linear or branched. The alkoxy group is bond to the silicon atom in general formula (I) via the oxygen atom. Examples for a linear alkoxy groups are methoxy, ethoxy, *n*-propoxy, *n*-butoxy, *n*-pentoxy, *n*-hexyloxy, *n*-heptyloxy, *n*-octyloxy, *n*-nonyloxy, *n-*decyloxy. Examples for a branched alkoxy groups are *iso*-propoxy, *iso*-butoxy, *sec*-butoxy, *tert-*butoxy, 2-methyl-pentoxy, 2-ethyl-hexoxy, cycloproplyoxy, cyclohexyloxy, indanyloxy, norbornyloxy. Preferably, the alkoxy group is a C₁ to C₁₂ alkoxy group, more preferably a C₂ to C₁₀ alkoxy group, in particular a C₄ to C₈ alkoxy group. Alkoxy groups can be substituted for example by halogens like fluoride, chloride, bromide, iodide; by pseudohalogens like cyanide, cyanate, thiocyanate; by alcohols or by ethers. Unsubstituted alkoxy groups are preferred. Preferred examples for a compound of general formula (I) in which X is an alkoxy group include tetramethyl orthosilicate, tetraisopropyl orthosilicate or tetrabutyl orthosilicate.

Aryloxy groups include an aryl group which is bond via an oxygen atom to the silicon atom in general formula (I). Aryl groups include aromatic hydrocarbons such as phenyl, naphthalyl, anthrancenyl, phenanthrenyl groups and heteroaromatic groups such as pyrryl, furanyl, thienyl, pyridinyl, quinoyl, benzofuryl, benzothiophenyl, thienothienyl. Several of these groups or combinations of these groups are also possible like biphenyl, thienophenyl or furanylthienyl. Aryl groups can be substituted for example by halogens like fluoride, chloride, bromide, iodide; by pseudohalogens like cyanide, cyanate, thiocyanate; by alcohols; alkyl groups such as methyl or ethyl; or alkoxy groups such as methoxy or ethoxy. Aromatic hydrocarbons are preferred, phenyl is more preferred. Preferably, the aryloxy group contains 4 to 18 carbon atoms, in particular 4 to 8. Preferred examples for a compound of general formula (I) in which X is an alryloxy group include tetraphenyl orthosilicate, tetratolyl orthosilicate.

An amine can be an NH₂ group or an NH₂ group in which one or both hydrogens are substituted by an alkyl or an aryl group as described above for the alkoxy and the aryloxy group. If both hydrogens are substituted, the substituents can be the same or different to each other, preferably they are the same. Preferred examples for a compound of general formula (I) in which X is an amine are tetrakis(dimethylamino)silane or bis(dimethylamino)dimethoxysilane.

The compound of general formula (I) is capable of forming covalent bonds with the surface of the solid substrate. Preferably, it does not form bonds with the organic compound (A). In this way, the surface of the solid substrate is completely or substantially completely covered by a monolayer containing the organic compound (A) and the compound of general formula (I).

### Step (c)

According to the present invention the solid substrate is exposed to a vapor containing an organic compound (B) which has at least two functional groups out of which at least one can form a covalent bond with the surface-bound organic compound (A). The at least two functional groups of the organic compound (B) can be the same or different to each other, preferably they are the same. At least one of the functional groups needs to be able to form a covalent bond with the surface-bound organic compound (A). If the organic compound (A) contains a reactive carbonyl group, it is for example possible that the organic compound (B) contains amine groups, for example 1,4-phenylenediamine. Other examples include groups capable of participating in an electrocyclic addition reaction such as dienes, azides, ethynes, or nitriles. Preferably, the organic compound (B) contains functional groups which can form amines when brought in contact with water, e.g. in step (d1), in particular when the organic compound (A) contains an amine. An example for such a functional group is an isocyanate. Preferred examples for the organic compound (B) are toluenediisocyanate (TDI) or methylenediphenylisocyanate (MDI).

### Step (d)

According to the present invention the process further comprises the steps (d1) exposing the solid substrate to a vapor containing water, and (d2) exposing the solid substrate to a vapor containing a compound of general formula (I). Exposing the solid substrate to a vapor containing water leads to hydrolysis of the compound of general (I) which forms Si-OH groups. These Si-OH groups can react with the compound of general formula (I) upon exposure of the solid substrate to a vapor containing a compound of general formula (I). The sequence including steps (d1) and (d2) is preferably performed more than once, such as 2 to 30 times, preferably 3 to 20, in particular 4 to 10 times. It is possible to use the same compound of general formula (I) every time step (d2) is performed or different ones. Preferably, the same compound of general formula (I) is used.

### Step (e)

According to the present invention the process further comprises exposing the solid substrate to a vapor containing an organic compound (C) which has at least two functional groups out of which at least one can form a covalent bond to the surface-bound organic compound (B). The at least two functional groups of the organic compound (C) can be the same or different to each other, preferably they are the same. At least one of the functional groups needs to be able to form a covalent bond with the surface-bound organic compound (B). Preferably, the organic compound (B) and the organic compound (C) both contain isocyanate groups, more preferably the organic compound (B) and the organic compound (C) are the same, in particular toluenediisocyanate (TDI) or methylenediphenylisocyanate (MDI).

### Step (f)

According to the present invention the process further comprises removing organic parts from the film formed on the surface of the solid substrate. This can preferably be done by heating the solid substrate to a temperature of at least 400 °C, preferably at least 450 °C, in particular at least 500 °C, and typically not more than 1000 °C depending on the solid substrate; irradiation with UV light such as UV light with a wavelength of 100 to 300 nm, preferably 150 to 250 nm; exposure to an oxidant such as H₂O₂, O₂ or O₃; or exposure to a plasma, such as an oxygen plasma or an argon plasma. Heating the solid substrate to a temperature of at least 400 °C or by exposing it to a plasma is preferred.

### Common provisions

The process according to the present invention comprises steps in which the solid substrate is exposed to a vapor containing various substances, i.e. the organic compound (A), (B), (C), the compound of general formula (I), or water. These substances are typically a liquid or a solid at normal conditions (temperature of 25 °C and a pressure of 1013 mbar). In order to bring the substances into the gaseous state it can be heated to elevated temperatures. In any case a temperature below the decomposition temperature of the respective substance has to be chosen. Preferably, the heating temperature ranges from slightly above room temperature to 400 °C, more preferably from 30 °C to 300 °C, even more preferably from 40 °C to 250 °C, in particular from 50 °C to 200 °C.

Another way of bringing the substances into the gaseous state is direct liquid injection (DLI) as described for example in US 2009 / 0 226 612 A1. In this method the respective substance is typically dissolved in a solvent and sprayed in a carrier gas or vacuum. Various solvents can be used provided that the respective substance shows sufficient solubility in that solvent such as at least 1 g/l, preferably at least 10 g/l, more preferably at least 100 g/l. Examples for these solvents are coordinating solvents such as tetrahydrofuran, dioxane, diethoxyethane, pyridine or non-coordinating solvents such as benzene, toluene, or xylene. Solvent mixtures are also suitable.

It is preferred to bring the respective substance into the gaseous state at decreased pressure. In this way, usually lower heating temperatures are required leading to decreased decomposition of the compound of general formula (I). Typical pressures range from 10⁻⁶ to 1500 mbar, more preferably from 10⁻² to 100 mbar, in particular from 0.1 to 10 mbar.

The vapor containing the respective substance can additionally contain a carrier gas, preferably an inert gas such as nitrogen or argon. The vapor can be at various pressures, such as 10⁻⁶ to 1500 mbar, preferably 10 to 1200 mbar, in particular at normal pressure. The exposure of the solid substrate to the vapor can be effected for example by putting the solid substrate into a vacuum chamber which is filled by the vapor. Alternatively, the solid substrate can be moved relative to an orifice through which the vapor is passed onto the substrate.

Preferably, the solid substrate is heated to an elevated temperature when being exposed to the vapor containing the respective substances, such as from room temperature to 400 °C, more preferably from 30 °C to 300 °C, even more preferably from 40 °C to 250 °C, in particular from 50 °C to 200 °C. It is possible to keep the solid substrate at the same temperature during the whole process or to use a different temperature for each process step. Preferably the solid substrate is kept at the same temperature during the whole process.

The exposure of the solid substrate to the respective vapor can take 1 ms to 1 h, preferably 100 ms to 10 min, in particular 1 s to 1 min. Preferably, after the solid substrate has been exposed to a vapor containing a respective substance, any or substantially any remainder of this substance in the vapor phase is removed. This can be done by applying a vacuum or by flushing with an inert gas, such as nitrogen or argon, over the surface of the solid substrate.

By exposing the solid substrate to a vapor containing the respective substances, these substances are deposited onto the surface of the solid substrate in a self-limiting reaction. A deposition process comprising a self-limiting process step and a subsequent self-limiting reaction is often referred to as atomic layer deposition (ALD). Equivalent expressions are molecular layer deposition (MLD) or atomic layer epitaxy (ALE). Hence, the process according to the present invention is preferably an ALD process. The ALD process is described in detail by George (Chemical Reviews 110 (2010), 111-131).

Preferably, the sequence containing steps (b) to (e) is performed at least 10 times before step (f) is performed, more preferably at least 20 times, in particular at least 50 times. If the sequence containing steps (b) to (e) is performed more than once, in between each such sequence the solid substrate is preferably exposed to a vapor containing water as described for step (d1). Normally, the sequence is not performed more than 500 times.

The present invention further relates to an amorphous film on a solid substrate comprising silica having a thickness of up to 300 nm and pores with a volume average diameter of 0.1 to 4 nm wherein the standard deviation of the pore diameter is not more than 20 % of the volume average diameter.

Preferably, the amorphous film is made by the process according to the invention. The definitions and preferred embodiments described for the process apply to the amorphous film where applicable.

Amorphous in the context of the present invention means that the height of peaks in a wide-angle X-ray diffractogram of the film are not more than 10 %, preferably not more than 5 %, in particular not more than 1 % of the height of the corresponding peaks of a perfectly crystalline silica film of the same dimensions.

The thickness of the amorphous film is up to 300 nm, preferably up to 200, more preferably up to 100 nm, in particular up to 50 nm. Usually, the amorphous film has a thickness of at least 0.1 nm, preferably at least 1 nm. The film thickness can be measured by transmission electron microscopy.

The amorphous film contains pores with a volume average diameter of 0.1 to 4 nm, preferably 0.2 to 3 nm, in particular 0.3 to 2 nm, such as 0.5 to 1 nm. The standard deviation of the pore diameter is not more than 20 % of the volume average diameter, preferably not more than 15 %, in particular not more than 10 %. The pore size and pore size distribution can be measured by ellipsometric porosimetry, described for example in Microelectronic Engineering 64 (2002) 335-349.

Preferably, the porosity of the amorphous film is at least 20 %, more preferably at least 30 %, in particular at least 40 %.

Preferably, the pores in the amorphous film are anisotropic. The diameter along the direction of largest diameter is at least 20 % more than the diameter along the direction of the smallest diameter, preferably at least 50 %, in particular at least 100 %. The anisotropy of the pore diameter can be measured by ellepsiometric porosimetry by measuring both adsorption and desproption branches, also described in for example Microelectronic Engineering 64 (2002) 335-349.

Preferably, the amorphous film is conformal on the solid substrate which means that the surface profile of the amorphous film is essentially the same at that of the solid substrate.

The amorphous film according to the present invention has a high mechanical strength in comparison to amorphous films from prior art as they are free of any grain boundaries.

The amorphous film according to the present invention has a low dielectric constant. The dielectric constant is typically 1.5 to 3.0, preferably 1.8 to 2.5. Therefore, the amorphous film can be used as insulator, in particular in electronic elements. The electronic elements can have structural features of various sizes, for example from 10 nm to 100 µm. The process for forming the amorphous films for the electronic elements is particularly well suited for very fine structures. Therefore, electronic elements with sizes below 1 µm are preferred. Examples for electronic elements are field-effect transistors (FET), solar cells, light emitting diodes, sensors, or capacitors. Transistors are preferred electronic elements.

## Claims

1. A process for producing porous films comprising the steps
(a) exposing a solid substrate to a vapor containing an organic compound (A), whereby a submonolayer of the organic compound (A) covalently bound to the surface of the solid substrate is formed,
(b) exposing the solid substrate to a vapor containing a compound of general formula (I) SiX₄ (I),
wherein X is hydrogen, a halogen, an alkoxy, an aryloxy, or an amine group,
(c) exposing the solid substrate to a vapor containing an organic compound (B) which has at least two functional groups out of which at least one can form a covalent bond with the surface-bound organic compound (A),
(d) performing the steps
(d1) exposing the solid substrate to a vapor containing water, and
(d2) exposing the solid substrate to a vapor containing a compound of general formula (I),
(e) exposing the solid substrate to a vapor containing an organic compound (C) which has at least two functional groups out of which at least one can form a covalent bond to the surface-bound organic compound (B),
(f) removing organic parts from the film formed on the surface of the solid substrate.

2. The process according to claim 1 wherein step (d) is performed 2 to 30 times in between step (c) and step (e).

3. The process according to claim 1 or 2 wherein the sequence containing steps (b) to (f) is performed at least 20 times before step (g) is performed.

4. The process according to any of the claims 1 to 3 wherein the organic compound (A) contains an azasilyl group.

5. The process according to any of the claims 1 to 4 wherein the organic compound (A) and (C) contain an amine group and the organic compound (B) contains an isocyanate group.

6. The process according to any of the claims 1 to 4 wherein the organic compound (B) and the organic compound (C) are both toluene diisocyanate.

7. The process according to any of the claims 1 to 6 wherein step (g) is performed by heating the solid substrate to a temperature of at least 400 °C or by exposing it to a plasma.

8. An amorphous film on a solid substrate comprising silica having a thickness of up to 300 nm and pores with a volume average diameter of 0.1 to 4 nm wherein the standard deviation of the pore diameter is not more than 20 % of the volume average diameter.

9. The film according to claim 8 wherein the pores are anisotropic.

10. The film according to claim 8 or 9 wherein the film is conformal on the solid substrate.

11. The film according to any of the claims 8 to 10 wherein the solid substrate comprises silicon.

12. Use of the film according to any of the claims 8 to 11 as insulator.

13. An electronic element comprising the film according to any of the claims 8 to 11.

14. The electronic element according to claim 13 where in the electronic element is a transistor.
